Europäisches Patentamt

European Patent Office

Office Européen des brevets

(11) Publication number: **0 252 174 B1**

# EUROPEAN PATENT SPECIFICATION

(45) Date of publication of patent specification:
**02.01.91 Bulletin 91/01**

(51) Int. Cl.⁵: **G02B 21/26, H01J 37/20, B23Q 1/14, B25J 7/00**

(21) Application number: **86109284.9**

(22) Date of filing: **08.07.86**

(54) **Coarse-approach positioning device.**

(43) Date of publication of application:
**13.01.88 Bulletin 88/02**

(45) Publication of the grant of the patent:
**02.01.91 Bulletin 91/01**

(84) Designated Contracting States:
**CH DE FR GB IT LI**

(56) References cited:
**DE-A- 2 800 340**
**DE-B- 2 542 354**
**US-A- 3 407 018**

(73) Proprietor: **International Business Machines Corporation**
**Old Orchard Road**
**Armonk, N.Y. 10504 (US)**

(72) Inventor: **Binnig, Gerd Karl, Dr.**
**Feldstrasse 16**
**CH-8805 Richterswil (CH)**
Inventor: **Gerber, Christoph Emanuel**
**Sonnenbergstrasse 47**
**CH-8134 Adliswil (CH)**

(74) Representative: **Rudack, Günter O., Dipl.-Ing.**
**IBM Corporation Säumerstrasse 4**
**CH-8803 Rüschlikon (CH)**

## Description

The invention relates to a coarse-aaproach positioning device intended for approaching a sample towards a tool or measuring device, or vice-versa. In particular, this device may find application in the microscope art, for example in connection with scanning tunneling microscopes or scanning electron microscopes.

In the microscope art, it is always necessary to position the sample to be investigated as closely as possible to the point of best observation. In the case of the tunneling microscope the sample should be placed at a distance between 0,1 and 1 nanometer from the tunneling tip, in the case of the scanning electron microscope, the sample should be placed at the focal point of the electron beam, again with a tolerance in the nanometer range.

The positioning of a sample to within one nanometer from an optimum location usually cannot be accomplished in a single step. Typically, first a coarse approach is performed by which the sample is brought to within one micrometer of the optimum location, and then a fine approach mechanism takes over to accomplish the positioning to the desired tolerance.

Well known in the microscope art are rack-and-pinion devices for coarse adjustment, and screw appliances for fine adjustment. However, it is to be noted that the terms "coarse" and "fine" when used in connection with optical microscopes define an entirely different magnitude of adjustment than is required in connection, for example, with the tunneling microscope. The reason is that the tunneling microscope has a resolution at least three orders of magnitude better than conventional optical microscopes. In other words, the conven- tional fine-adjustment appliance of an optical microscope is certainly too coarse to serve as the coarse-approach adjustment mechanism for a tunneling microscope.

Several coarse-approach positioning devices for use with the scanning tunneling microscope have already been proposed. All use pizoelectric elements to accomplish movements in steps of several micrometers each, such as those disclosed in EP-A- 71 666, EP-A-160 707, US-A 4,520,570, IBM Technical Disclosure Bulletin Vol.26, No. 10A (1984) pp. 4898 and 5175. Coarse and fine adjustment can be performed by a device taught by IBM Technical Disclosure Bulletin Vol.22, No. 7 (1979) p. 2897.

The devices known in the prior art have one or both of the following disadvantages : They do not operate at cryogenic temperatures or in ultra-high vacuum ; they transmit vibrations to the sample so that a sharp image of the sample surface cannot be obtained.

It is accordingly an object of the present invention to propose a coarse approach positioning device which is capable of sustaining cryogenic and ultra-high vacuum environments, and which is of such a rigid construction that vibrations are neither generated nor propagated.

The above-stated and other objects of the invention are achieved by a coarse-approach positioning device for approaching an object to a predetermined position with a resolution on the order of micrometers, particularly for use in the microscope art, which positioning device is characterized in that the object is attached to a movable block which is tiltably supported along one of its edges and balanced between at least a first spring and a second spring, the springs having different spring characteristics, said movable block being tilted through enforced deflection of one of the springs upon actuation by a pressure member, the angle of tilting of said block being determined by the relationship of the spring characteristics of said first and second springs, respectively, such that deflection of said first spring through a predetermined first distance causes a resultant deflection of said second spring through a second distance smaller than said first distance and, hence, causes movement of said block through a third distance smaller by at least one order of magnitude than the movement of siad pressure member.

Details of several embodiments of the coarse-approach positioning device of the present invention will hereafter be described by way of example, with reference to the attached drawings in which :

Fig.1 is a schematic representation of a first embodiment of a coarse-approach positioning device ;

Fig.2 is a schematic representation of a second embodiment of a coarse-approach positioning device ;

Fig.3 is a perspective view of a third embodiment of the invention ;

Fig.4 is a cross-section along line A-A of the embodiment of Fig.3 (not to scale).

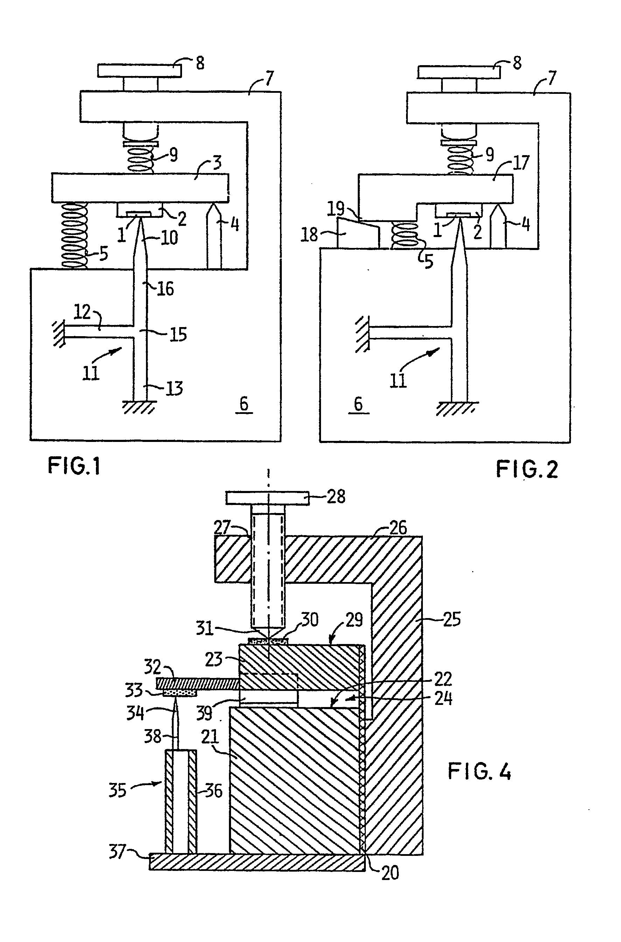

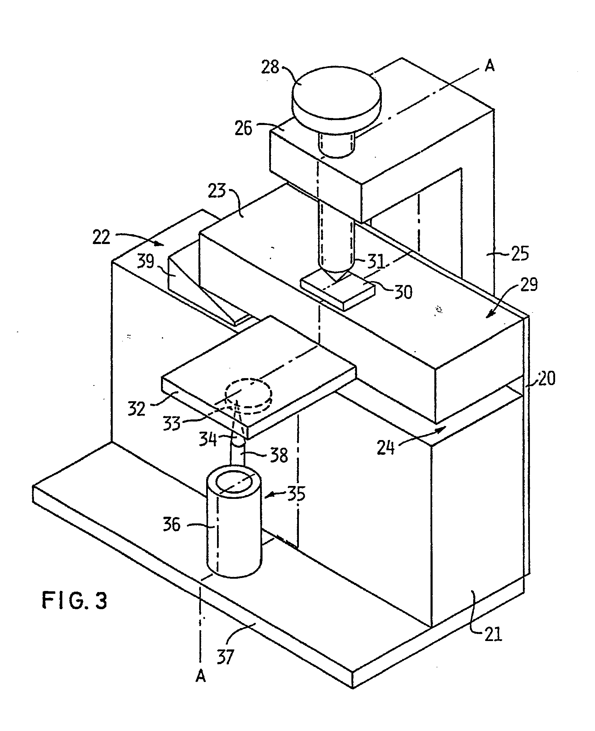

Referring to Fig.1, the object or sample 1 to be positioned is attached to a sample holder 2 which in turn is fixed to a block 3. Resting on a tilting knife 4 is one edge of the bottom side of block 3, while the other edge thereof is supported by a first spring 5. Tilting knife 4 and spring 5 rest on a common frame 6 of which one arm 7 supports an adjustment screw 8 which acts on a second spring 9 arranged between said screw 8 and the upper surface of block 3.

Since a scanning tunneling microscope was chosen for the explanation of positioning device in accordance with the invention, a tunnel tip 10 is mounted to a tripod 11 having three legs 12, 13 and 14 (leg 14 extending vertically into the plane of the drawing and not visible in Fig.1), each leg being associated with one coordinate of an xyz coordinate system and having one end fixed to frame 6. The other ends of legs 12, 13 and 14 are connected in a common joint 15. The legs 12...14 of tripod 11 may, for example, consist of piezoelectric elements which can be caused to expand or contract by way of applying electric potentials to the electrodes they carry (not shown). Tripods of this type are known in the art, e.g. from IBM Technical Disclosure Bulletin Vol.27,No.10B (1984) p.5976. With tunnel tip 10 mounted on an arm 16 of tripod 11, even fine-adjustment of the distance between tunnel tip 10 and sample 1 can be performed.

In Fig.1, sample 1 is supported between two springs, 5 and 9. Depending on the ratio of the spring constants, i.e. with spring 5 being harder than spring 9, the resulting movement of sample 1 will be proportionally smaller than the movement of screw 8 when turned.

It is to be understood that the tilting action performed by block 3, as screw 8 is lowering and compressing spring 5, is so small that for the purposes of this invention the motion of sample 1 attached to block 3 can be considered linear, as opposed to occurring on a circle, as is mathematically correct.

One embodiment of the coarse-approach positioning device in accordance with with Fig.1 had an eigenfrequency against the tripod that was considered too low, leading to a tendency of propagating vibrations. This disadvantage can be overcome with a positioning device in accordance with Fig.2.

Referring to Fig.2, there is shown sample 1 held by a sample holder 2 which is attached to a block 17 that rests, along one edge, on a tilting knife 4. Block 17 is balanced between springs 5 and 9 which may have different spring constants as explained above. So far, this arrangement is similar to the embodiment in accordance with Fig.1. The approach of sample 1 towards tunnel tip 10 down to a distance of about 2 micrometers may be controlled with an optical microscope, or by field-emission under ultra-high vacuum. When this distance is reached, spring 5 is complemented with a considerably harder spring which may take the form of a wedge 18 resting on frame 6.

By turning screw 8 and compressing springs 5 and 9, block 17, with its shoulder 19, will eventually touch down upon wedge 18 so that block 17 will become balanced between spring 9 and wedge 18, with spring 5 only contributing negligibly. Wedge 18 may, e.g. consist of rubber, or better viton, but in any case must have a spring constant at least one order of magnitude greater than spring 5. As screw 8 is now turned further, block 17 will be moving at a considerably slower pace than before.

Still another embodiment of the positioning device in accordance with the invention is shown in Figs. 3 and 4 being respectively a perspective view and a cross-section of the same embodiment (though not drawn to scale). In the embodiment of Figs. 3 and 4, tilting knife (4) and spring (5) on which the block (3, 17) carrying the sample (1) rests in Figs. 1 and 2, have been combined into one single element, viz. a leaf spring (20).

Referring to Figs. 3 and 4, leaf spring 20 is fixed to a frame 21 (equivalent of frame 6 in Figs. 1 and 2) and extends beyond the upper surface 22 thereof. Attached to leaf spring 20 is a block 23 in such a way that a gap 24 is formed between frame 21 and block 23. Gap 24, of course, extends parallel with the surface 22 of frame 21. An arm 25 is screwed to frame 21 on the back of leaf spring 20 such that block 23 is free to move without interfering with arm 25, as shown in Fig. 4. Arm 25 in its horizontal section 26 has a thread 27 with very low pitch, which accomodates a pressure screw 28.

On the top surface 29 of block 23 there rests a pad 30 consisting of elastic material. The lower end 31 of screw 28 is aligned to engage pad 30 when screw 28 is threaded through. The pressure thus exerted on pad 30 will cause block 23 to be tilted to the left in Fig. 4 as leaf spring 20 bends. The amount of tilting of block 23 is determined by the geometric parameters of the embodiment including, of course, the movement of screw 28, as well as by the relationship of the spring constants of elastic pad 30 and leaf spring 20, respectively. As a general rule, the spring constant of leaf spring 20 will be chosen much higher than that of pad 30.

Extending from block 23 at the side opposite leaf spring 20 is a sample holder 32. Held on the lower surface of sample holder 32 is the sample 33 to be inspected. The inspection is made with the aid of a sharply pointed tunnel tip 34 which is attached to a fine-approach and scanning device 35. Device 35 may, e.g. comprise the tripod 11 of Figs. 1 and 2. In the embodiment of Figs. 3 and 4 it is realized in the form of a piezoceramic tube 36 which, together with frame 21, rests on a common base plate 37. As is known in the art, tube 36 carries pairs of electrodes attached to diagonally opposite surface areas thereof which, when energized with voltages of appropriate waveform and phase, enable tube 36 to perform linear or circular motion. Attached to the upper end of tube 36 is tunnel tip 34. As tube 36 moves, tunnel tip 34 scans the surface of sample 33 along such tracks as determined by the voltages applied.

Either the stem 38 of tunnel tip 34 or the fine-approach and scanning device 35 may be designed to be controllable by a feedback signal derived from the tunneling current flowing across the tunnel gap between tunnel tip 34 and sample 33, and being a measure for the width of that gap, as is well known in the scanning tunneling microscope art.

The tilting movement of block 23 and, hence, the (essentially) vertical movement of sample 33 are derived from the movement of screw 28 as modified by the relationship of the spring constants of leaf spring 20 and elastic pad 30. With the arrangement of Figs. 3 and 4 so far described it will be possible to approach sample 33 towards tunnel tip 34 to within a fraction of one micrometer.

When that distance has been reached, -and this can be determined through inspection with an optical microscope,- the relationship of the spring constants is changed by inserting a wedge 39 into gap 24 so that block 23 with one edge now rests on said wedge. The movement of block 23, as screw 28 is turned, now depends on the relationship of the spring constants of pad 30 and wedge 39. In this case, the contribution of leaf spring 20 is negligible.

With wedge 39 inserted in gap 24, and wedge 24 assumed to consist of a material with low elasticity, it is easily possible to position sample 33 within the tunneling region, i.e. with a gap between sample 33 and tunnel tip 34 on the order of one nanometer.

As mentioned before, fine adjustment during scanning operation is made by energizing fine-approach device 35.

## Claims

1. Coarse-approach positioning device for approaching an object to a predetermined position with a resolution on the order of micrometers, particularly for use in the microscope art, where in the object (1, 33) to be positioned is attached to a movable block (3, 17, 23) which is tiltably supported (4, 20) along one of its edges and balanced between at least a first spring (5, 20) and a second spring (9, 30) having different spring characteristics, said movable block (3, 17, 23) being tilted through enforced deflection of one of the springs (9, 30), upon actuation of a pressure member (8), the angle of tilting of said block (3, 17, 23) being determined by the relationship of the spring characteristics of said first and second springs (5, 20; 9, 30), respectively, such that deflection of the said second spring (9, 30) through a predetermined first distance causes a resultant deflection of said first spring (5, 20) through a second distance smaller than said first distance and, hence, causes movement of said block (3, 17, 23) through a third distance smaller by at least one order of magnitude than the movement of said pressure member (8).

2. Positioning device in accordance with claim 1, characterized in that said block (17, 23) is tiltably supported (4, 20) along one of its edges and balanced between said second spring (9, 30) and said first spring (5, 20) during its tilting through a pre- determined angle, and balanced between said second spring (9, 30) and a third spring (18, 39) during its tilting beyond said pre-determined angle, said third spring (18, 39) having a spring constant greater than the one of said first spring (5, 20), such that continued deflection of said second spring (9, 30) through a given distance for the tilting of said block (17, 23) beyond said predetermined angle and with said third spring (18, 39) being active, results in a tilting action through a fourth distance still smaller than said third distance.

3. Positioning device in accordance with claim 1, characterized in that said block (3) is supported on a knife (4) and on said first spring (5), both resting on a common frame (6), that on the top of said block (3) said second spring is arranged which can be compressed against said block (3) by means of a manually operable screw (8) turnably supported by a thread in an arm (7) extend- ing from said frame (6), said block (3) performing a tilting movement about said knife (4) so as to approach said object (1) towards a working position which may be defined as the focal point of a lens system, and/or as the tunneling region in a tunneling microscope.

4. Positioning device in accordance with claim 2, characterized in that for tilting through said predetermined angle said block (17) is supported on a knife (4) and on said first spring (5), both resting on a common frame (6), that on the top of said block (17) said second spring (9) is arranged which is compressible against said block (17) by means of a manually operable screw (8) turn- ably supported in a thread in an arm (7) extending from said frame (6), and that for tilting beyond said predetermined angle, said first spring (5) automatically becomes replaced by said third spring (18) arranged in juxtaposition with said first spring (5) but being much harder than the latter.

5. Positioning device in accordance with claim 2, characterized in that for tilting through said predetermined angle said block (23) is supported by a leaf spring (20) constituting said first spring attached along one side of said block (23) and to a frame (21) so as to keep said block (23) in a parallel relationship with said frame (21) with a gap (24) in between, that on the top of said block (23) an elastic pad (3) constituting said second spring is arranged for cooperation with a pressure screw (28) supported in a thread (27) of an arm (26) fixed to said frame (21), and that for tilting of said block (21) beyond said predetermined angle, said leaf spring (20) automatically becomes shunted by said third spring (39) insertable into said gap (24) between said block (23) and said frame (21).

6. Positioning device in accordance with claim 5, characterized in that said object (33) is attached to a holder (32) extending from said block (23) and is aligned with a fine-approach and scanning device (35) carrying a tunnel tip (34).

7. Positioning device in accordance with claim 4 or claim 5, characterized in that said third spring takes the form of a wedge (18, 39) made of elastic material.

8. Positioning device in accordance with claim 7, characterized in that said predetermined angle through which said first spring (5, 20) is active, is adjustable through insertion and retraction of said wedge (18, 39) in said gap (24) between said block (17, 23) and said frame (6, 21).

## Ansprüche

1. Grobstellanordnung für das Einstellen eines Objektes auf eine vorgegebene Position mit einer Genauigkeit im Mikrometerbereich, insbesondere in der Mikroskoptechnik, wobei das einzustellende Objekt (1, 33) an einem bewegbaren Block (3, 17, 23) angeordnet ist, der entlang einer seiner Kanten neigbar gehalten (4, 20) und zwischen wenigstens einer ersten Feder (5, 20) und einer unterschiedliche Federeigenschaften aufweisenden zweiten Feder (9, 30) im Gleichgewicht gehalten ist, wobei der bewegbare Block (3, 17, 23) bei durch ein Druckelement (8) erzwungener Auslenkung einer der Federn (9, 30) geneigt wird und der Neigungswinkel des genannten Blocks (3, 17, 23) durch das Verhältnis der Federeigenschaften der genannten ersten und zweiten Federn (5, 20 ; 9, 30) derart bestimmt ist, daß die Auslenkung der genannten zweiten Feder (9, 30) um eine vorbestimmte erste Distanz eine resultierende Auslenkung der genannten ersten Feder (5, 20) um eine zweite Distanz hervorruft, die kleiner als die erste Distanz ist, und dadurch eine Bewegung des genannten Blocks (3, 17, 23) um eine dritte Distanz bewirkt, die wenigstens um eine Größenordnung kleiner ist, als die Bewegung des genannten Druckelements (8).

2. Grobstellanordnung gemäß Anspruch 1, dadurch **gekennzeichnet**, daß der genannte Block (17, 23) entlang einer seiner Kanten neigbar gehalten (4, 20) ist und während seiner Neigung um einen vorgegebenen Winkel zwischen der genannten zweiten Feder (9, 30) und der genannten ersten Feder (5, 20) im Gleichgewicht gehalten ist, und während seiner Neigung um einen größeren als den vorgegebenen Winkel zwischen der genannten zweiten Feder (9, 30) und einer dritten Feder (18, 39) im Gleichgewicht gehalten ist, wobei die genannte dritte Feder (18, 39) eine größere Federkonstante aufweist als die genannte erste Feder (5, 20), derart, daß fortgesetzte Auslenkung der genannten zweiten Feder (9, 30) um eine gegebene Distanz für die Neigung des genannten Blocks (17, 23) über den genannten vorgegebenen Winkel hinaus und bei aktiver dritter Feder (18, 39), zu einer Neigung um eine vierte Distanz führt, die noch kleiner ist, als die genannte dritte Distanz.

3. Grobstellanordnung gemäß Anspruch 1, dadurch **gekennzeichnet**, daß der genannte Block (3) auf einer Schneide (4) und auf der genannten ersten Feder (5) gehalten ist, die beide auf einem gemeinsamen Rahmen (6) ruhen, daß die genannte zweite Feder auf der Oberseite des Blocks (3) angeordnet ist und mittels einer manuell einstellbaren Schraube (8), die in einem von dem Rahmen (6) ausgehenden Arm (7) vorgesehenen Gewinde drehbar ist und gegen den Block (3) gedrückt werden kann, und der Block (3) eine Neigung um die genannte Schneide (4) ausführt und das Objekt (1) in eine Arbeitsposition bringt, die als Brennpunkt eines Linsensystems und-

/oder als Tunnelbereich in einem Tunnelmikroskop definiert werden kann.

4. Grobstellanordnung gemäß Anspruch 2, dadurch **gekennzeichnet**, daß der genannte Block (17) zum Neigen um den genannten vorgegebenen Winkel auf einer Schneide (4) und auf der genannten ersten Feder (5) gehalten ist, die beide auf einem gemeinsamen Rahmen (6) ruhen, daß die genannte zweite Feder auf der Oberseite des Blocks (3) angeordnet ist und mittels einer manuell einstellbaren Schraube (8), die in einem von dem Rahmen (6) ausgehenden Arm (7) vorgesehenen Gewinde drehbar ist und gegen den Block (3) gedrückt werden kann, und daß für eine Neigung um einen größeren als den vorgegebenen Winkel die genannte erste Feder (5) automatisch durch die genannte dritte Feder (18) ersetzt wird, die neben der genannten ersten Feder (5) angeordnet aber viel härter ist als jene.

5. Grobstellanordnung gemäß Anspruch 2, dadurch **gekennzeichnet**, daß der genannte Block (23) zum Neigen um den genannten vorgegebenen Winkel auf einer die genannte erste Feder verkörpernden Blattfeder (20) angeordnet ist, die entlang einer Seite des Blocks (23) und an einem Rahmen (21) befestigt ist und den Block (23) parallel zum genannten Rahmen (21) und mit einem Spalt (24) zwischen beiden hält, daß auf der Oberseite des Blocks (23) ein die genannte zweite Feder verkörperndes elastisches Kissen (3) für ein Zusammenwirken mit einer Druckschraube (28) vorgesehen ist, die in einem von dem Rahmen (21) ausgehenden Arm (7) in einem Gewinde drehbar ist, und daß für das Neigen des Blocks (23) über den vorgegebenen Winkel hinaus die genannte Blattfeder (20) automatisch durch die genannte dritte Feder (39) überbrückt wird, die in den Spalt (24) zwischen dem genannten Block (23) und dem Rahmen (21) einsetzbar ist.

6. Grobstellanordnung gemäß Anspruch 5, dadurch **gekennzeichnet**, daß das genannte Objekt (33) an einem Halter (32) befestigt ist, der von dem genannten Block (23) auskragt und mit einer eine Tunnelspitze (34) tragenden Feinstell- und Abtastvorrichtung (35) ausgerichtet ist.

7. Grobstellanordnung gemäß Anspruch 4 oder Anspruch 5, dadurch **gekennzeichnet**, daß die genannte dritte Feder die Form eines Keils (18, 39) aufweist und aus elastischem Material besteht.

8. Grobstellanordnung gemäß Anspruch 7, dadurch **gekennzeichnet**, daß der vorgegebene Winkel, über den die genannte erste Feder (5, 20) aktiv ist, durch Einsetzen und Rückziehen des genannten Keils (18, 39) in bzw. aus dem Spalt (24) zwischen dem genannten Block (23) und dem Rahmen (6, 21) einstellbar ist.

## Revendications

1. Dispositif de réglage approximatif pour approcher un objet d'une position prédéterminée avec une précision de l'ordre de quelques micromètres, en particulier pour un usage en microscopie, dans lequel l'objet (1, 33) devant être positionné est fixé à un bloc déplaçable (3, 17, 23) qui est supporté de façon à pouvoir s'incliner (4, 20) le long d'un de ses bords et en équilibre entre au moins un premier ressort (5, 20) et un second ressort (9, 30) présentant des caractéristiques élastiques différentes, le bloc déplaçable (3, 17, 23) étant incliné du fait d'une flexion imposée de l'un des ressorts (9, 30), sous l'action d'un organe de pression (8), l'angle d'inclinaison du bloc (3, 17, 23) étant déterminé par la relation existant entre les caractéristiques élastiques respectivement des premier et second ressorts (5, 20 ; 9, 30), une telle flexion du second ressort (9, 30) selon une première distance prédéterminée provoquant une flexion résultante du premier ressort (5, 20) selon une seconde distance plus petite que la première distance et provoquant alors un mouvement du bloc (3, 17, 23) selon une troisième distance inférieure d'au moins un ordre de grandeur au déplacement de l'organe de pression (8).

2. Dispositif de réglage selon la revendication 1, caractérisé en ce que le bloc (17, 23) est supporté de façon inclinable (4, 20) le long d'un de ses bords et est en équilibre entre le second ressort (9, 30) et le premier ressort (5, 20) pendant son inclinaison selon un angle prédéterminé, et est en équilibre entre le second ressort (9, 30) et un troisième ressort (18, 39) lors de son inclinaison au-delà dudit angle pédéterminé, le troisième ressort (18, 39) ayant une constante d'élasticité supérieure à celle du premier ressort (5, 20), de sorte que la flexion qui se poursuit du second ressort (9, 30) selon une distance donnée pour incliner le bloc (17, 23) au-delà de l'angle prédéterminé et avec le troisième ressort (18, 39) entraîne une action d'inclinaison selon une quatrième distance encore plus petite que la troisième distance.

3. Dispositif de réglage selon la revendication 1, caractérisé en ce que le bloc (3) est en appui sur un couteau (4) et sur le premier ressort (5), les deux reposant sur un châssis commun (6), en ce que sur le haut du bloc (3) le second ressort est disposé de façon à pouvoir être comprimé contre le bloc (3) au moyen d'une vis actionnable manuellement (8) supportée par un bras (7) de façon à pouvoir tourner en se vissant, ce bras s'étendant à partir du châssis (6), le bloc (3) effectuant un mouvement d'inclinaison par rapport au couteau (4) de façon à approcher l'objet (1) vers une position de travail pouvant être définie comme le point focal d'un objectif et/ou comme la région d'effet tunnel d'un microscope à effet tunnel.

4. Dispositif de réglage selon la revendication 2, caractérisé en ce que, pour incliner le bloc (17) selon l'angle prédéterminé, le bloc (17) est supporté sur un couteau (4) et sur le premier ressort (5), les deux étant en appui sur un châssis commun (6), en ce que sur le haut du bloc (17) le second ressort (9) est disposé et est comprimé contre le bloc (17) au moyen d'une vis actionnable manuellement (8) reliée à un bras (7) s'étendant à partir du châssis (4) de façon à pouvoir tourner pour s'y glisser, et en ce que pour obtenir une inclinaison au-delà de l'angle prédéterminé, le premier ressort (5) est automatiquement remplacé par le troisième ressort (18) disposé de façon juxtaposée au premier ressort (5) mais étant beaucoup plus raide que ce dernier.

5. Dispositif de réglage selon la revendication 2, caractérisé en ce que pour obtenir une inclinaison selon l'angle prédéterminé, le bloc 23 est supporté par un ressort en forme de lame (20) constituant ledit premier ressort, fixé le long d'un des côtés du bloc (23) et fixé à un châssis (21) de façon à maintenir le bloc (23) selon une position parallèle par rapport au châssis (21), avec un espace (24) situé entre ceux-ci, en ce que sur le haut du bloc (23) est disposé un coussinet élastique (3) constituant ledit second ressort, afin de coopérer avec la vis de pression (28) reliée par un filetage (27) d'un bras (26) fixé sur le châssis (21) et en ce que pour obtenir une inclinaison du bloc (21) au-delà de l'angle prédéterminé, le ressort en forme de lame (20) commence automatiquement à être remplacé par le troisième ressort (39) qui peut être inséré dans ledit espace (24) situé entre le bloc (23) et le châssis (21).

6. Dispositif de réglage selon la revendication 5, caratérisé en ce que l'objet (33) est fixé à un support (32) s'étendant à partir du bloc (23) et est aligné sur un dispositif d'approche fine et de balayage (35) supportant une pointe à effet tunnel (34).

7. Dispositif de réglage selon la revendication 4 ou la revendication 5, caractérisé en ce que le troisième ressort présente la forme d'un coin (18, 39) réalisé en un matériau élastique.

8. Dispositif de réglage selon la revendication 7, caractérisé en ce que ledit angle prédéterminé selon lequel le premier ressort (5, 20) est mis en action, est réglable à l'aide d'une insertion et d'un retrait du coin (18, 39) dans l'espace (24) situé entre le bloc (17, 23) et le châssis (6, 21).

FIG.1

FIG.2

FIG. 4

FIG. 3